(19) Europäisches Patentamt

European Patent Office

Office européen des brevets

(11) **EP 1 435 101 B1**

(12) **FASCICULE DE BREVET EUROPEEN**

(45) Date de publication et mention
de la délivrance du brevet:
**21.12.2005 Bulletin 2005/51**

(21) Numéro de dépôt: **02785537.8**

(22) Date de dépôt: **10.10.2002**

(51) Int Cl.[7]: **H01F 10/32**, G11C 11/16,
G11B 5/39, H01F 41/30

(86) Numéro de dépôt international:
**PCT/FR2002/003448**

(87) Numéro de publication internationale:
**WO 2003/032338 (17.04.2003 Gazette 2003/16)**

(54) **DISPOSITIF MAGNETORESISTIF A VANNE DE SPIN A PERFORMANCES AMELIOREES**

MAGNETORESISTIVE HOCHLEISTUNGS-SPINVENTILANORDNUNG

SPIN-VALVE MAGNETORESISTIVE DEVICE WITH ENHANCED PERFORMANCE

(84) Etats contractants désignés:
**AT BE BG CH CY CZ DE DK EE ES FI FR GB GR
IE IT LI LU MC NL PT SE SK TR**

(30) Priorité: **12.10.2001 FR 0113174**

(43) Date de publication de la demande:
**07.07.2004 Bulletin 2004/28**

(73) Titulaire: **COMMISSARIAT A L'ENERGIE
ATOMIQUE
75752 Paris Cédex 15 (FR)**

(72) Inventeurs:
• **DIENY, Bernard
F-38250 Lans-en Vercors (FR)**
• **RODMACQ, Bernard
F-38113 Veurey-Voroize (FR)**
• **ERNULT, Franck, Bright City Appt 1106
Sendai (JP)**

(74) Mandataire: **Poulin, Gérard et al
Brevatome
3, rue du Docteur Lancereaux
75008 Paris (FR)**

(56) Documents cités:
**EP-A- 0 780 912          US-A- 5 463 516**

• **LECLAIR P ET AL: "TUNNEL CONDUCTANCE
AS A PROBE OF SPIN POLARIZATION DECAY
IN CU DUSTED CO/AL2O3/CO TUNNEL
JUNCTIONS" APPLIED PHYSICS LETTERS,
AMERICAN INSTITUTE OF PHYSICS. NEW
YORK, US, vol. 76, no. 25, 19 juin 2000
(2000-06-19), pages 3783-3785, XP000956875
ISSN: 0003-6951**
• **PATENT ABSTRACTS OF JAPAN vol. 2000, no.
20, 10 juillet 2001 (2001-07-10) & JP 2001 068760
A (HITACHI LTD), 16 mars 2001 (2001-03-16)**

**Description**

**DOMAINE TECHNIQUE**

La présente invention est relative à un dispositif magnétorésistif à vanne de spin. Ce dispositif peut trouver son application dans le domaine de l'enregistrement magnétique ultra-haute densité, en tant qu'élément sensible dans les têtes de lecture magnétorésistives de bandes magnétiques ou de disques durs d'ordinateurs. Ce dispositif peut aussi trouver son application dans la réalisation de points mémoire et de mémoire de type MRAM (pour « Magnetic Random Access Memory » ou mémoire magnétique à accès aléatoire).

**ETAT DE LA TECHNIQUE ANTERIEURE**

Dans le domaine des têtes magnétiques de lecture ainsi que dans celui des mémoires magnétiques à accès aléatoire, on utilise depuis peu des dispositifs magnétorésistifs à vanne de spin qui ont une vanne de spin formée d'un empilement de couches avec une couche séparatrice en sandwich entre deux couches magnétiques. L'orientation relative des directions d'aimantation de ces couches peut varier sous l'influence d'un champ magnétique. Dans certains dispositifs, les deux couches magnétiques ont une direction d'aimantation libre. On utilise alors les deux positions extrêmes où les deux directions d'aimantation sont soit parallèles, soit antiparallèles mais aussi toutes les positions intermédiaires. Dans d'autres dispositifs, l'une des couches magnétiques est libre et l'autre est dite piégée. La direction de son aimantation est fixée par une couche d'échange antiferromagnétique. Le brevet américain US 5 898 548 illustre une telle configuration, la couche séparatrice est une fine barrière diélectrique formant une jonction tunnel.

Des moyens pour faire circuler un courant perpendiculaire au plan des couches sont adjoints à la vanne de spin. Ils prennent la forme d'électrodes au sommet et à la base de la vanne de spin.

Il existe également des dispositifs dans lesquels le courant circule perpendiculairement au plan des couches, et qui ont leur vanne de spin entièrement métallique avec une couche métallique 10 continue en sandwich entre deux couches magnétiques 20, 30 comme dans le brevet américain US 5 668 688. Un tel dispositif est illustré sur la figure 1. La couche magnétique libre 30 et la couche magnétique piégée 20 sont séparées par une couche séparatrice 10 continue qui est électriquement conductrice et amagnétique pour assurer un découplage entre les deux couches magnétiques 20, 30. De part et d'autre des couches magnétiques 20, 30, ont été représentées des électrodes d'amenée de courant 60a, 60b.

Dans cet exemple, la couche magnétique piégée 20 est associée à une couche antiferromagnétique 21 qui contribue à maintenir fixe son aimantation. Elle est située entre la couche magnétique piégée 20 et l'électrode 60a associée. La couche magnétique libre 30 est associée à une couche tampon 31 (connue pour la dénomination de "buffer layer" en anglais) qui contribue à promouvoir la croissance de toutes les couches constitutives de la vanne de spin.

Ces derniers dispositifs sont souvent appelés dispositifs GMR (pour Giant MagnetoResistance en anglais) ou dispositifs à magnétorésistance géante.

Ces dispositifs magnétorésistifs à vanne de spin, à jonction tunnel ou à vanne de spin entièrement métallique à circulation de courant perpendiculairement au plan des couches, permettent d'augmenter la résolution spatiale de la tête magnétique le long des pistes.

Mais au point de vue de la sensibilité, ces dispositifs n'offrent pas toute satisfaction.

En effet, les dispositifs à jonction tunnel présentent un niveau de résistance trop élevé qui donne naissance à un bruit de grenaille important. Pour que le bruit de grenaille ait un niveau acceptable, il faudrait que le produit RA soit abaissé en dessous de 5 $\Omega.um^2$, ce produit RA est le produit de la résistance de la jonction par sa surface.

La résistance de la vanne de spin varie exponentiellement avec l'épaisseur de la barrière diélectrique. Pour obtenir une vanne de spin qui offre un produit RA atteignant 10 $\Omega.\mu m^2$, il faut que l'épaisseur de sa barrière ne soit que de 0, 5 nm ce qui est très faible. De plus, l'amplitude de la magnétorésistance de tels dispositifs avec barrière diélectrique décroît lorsqu'on essaye d'abaisser le produit RA en dessous d'environ 10 $\Omega.\mu m^2$. Ce n'est donc pas souhaitable.

Quant aux dispositifs magnétorésistifs à vanne de spin entièrement métallique, ils offrent un produit RA qui est très faible de l'ordre de 1 à 5 $m\Omega.\mu m^2$. Les surfaces de telles vannes de spin sont de l'ordre de quelques millièmes à quelques centièmes de micromètres carrés, pour des densités d'information à lire de l'ordre de 150 à 300 Gbit/pouce$^2$, ce qui conduit à des résistances de l'ordre de quelques dixièmes d'ohms. Ces valeurs sont trop faibles comparativement aux résistances de contact avec les électrodes d'amenée de courant, aux résistances des électrodes elles-mêmes. Les résistances des électrodes et des contacts sont en série avec celle de la vanne de spin, ce qui a pour effet de diluer le signal que l'on cherche à détecter.

Dans les mémoires à accès aléatoire, la résistance élevée de la jonction tunnel a comme inconvénient de conduire à une constante de temps élevée de la mémoire ce qui limite sa fréquence de fonctionnement. Le document EP-A-0 780 912 (l'état de la technique le plus proche) décrit un dispositif selon le préambule de la revendication 1 et un procédé selon le préambule de la revendication 17.

## EXPOSÉ DE L'INVENTION

La présente invention vise à réaliser un dispositif magnétorésistif à vanne de spin qui ne présente pas les inconvénients cités précédemment. Plus précisément, on cherche à réaliser un dispositif magnétorésistif à vanne de spin possédant une amplitude de magnétorésistance élevée tout en comportant un produit RA intermédiaire par rapport à ceux de l'art antérieur.

Pour y parvenir le dispositif magnétorésistif comporte une vanne de spin formée d'un empilement de couches parmi lesquelles au moins deux couches magnétiques dont l'orientation relative de leurs directions d'aimantation peut varier sous l'influence d'un champ magnétique, et des moyens pour faire circuler un courant dans la vanne de spin transversalement au plan des couches. La vanne de spin comporte dans l'une des couches magnétiques au moins une couche diélectrique ou semi-conductrice discontinue avec des ponts électriquement conducteurs qui traversent l'épaisseur de la couche diélectrique ou semi-conductrice, ces derniers étant destinés à concentrer localement le courant qui circule transversalement dans l'empilement.

Dans cette version, les ponts peuvent être réalisés dans le matériau magnétique de la couche accueillant la couche diélectrique ou semi-conductrice.

Une couche séparatrice continue électriquement conductrice, amagnétique peut être insérée entre la couche diélectrique ou semi-conductrice avec les ponts électriquement conducteurs et l'une au moins des couches magnétiques. Elle assure un découplage magnétique entre les deux couches magnétiques.

Les ponts électriquement conducteurs peuvent être réalisés dans un matériau amagnétique choisi parmi les métaux nobles tels que l'or, l'argent, le cuivre ou leurs alliages.

Dans une variante, ils peuvent être réalisés dans un matériau magnétique tel que le cobalt, le fer, le nickel ou leurs alliages.

Quant au matériau diélectrique ou semi-conducteur de la couche discontinue, il peut être magnétique ou amagnétique. Ce n'est pas une jonction tunnel. Son rôle est de dévier le courant qui circule dans l'empilement pour qu'il se concentre au niveau des ponts.

L'une des couches magnétiques peut avoir sa direction d'aimantation fixée par association d'une couche antiferromagnétique disposée au-delà de la couche magnétique à direction d'aimantation fixe par rapport à la couche diélectrique ou semi-conductrice avec les ponts électriquement conducteurs.

Au moins l'une des couches magnétiques peut être formée d'un empilement de couches intermédiaires.

Notamment, la couche magnétique à direction d'aimantation fixe peut être formée d'une couche intermédiaire électriquement conductrice amagnétique encadrée par deux couches intermédiaires magnétiques.

La couche diélectrique ou semi-conductrice discontinue peut être réalisée à base d'oxyde, de nitrure, de semi-conducteur.

Les moyens pour faire circuler un courant électrique peuvent comporter deux électrodes qui prennent en sandwich la vanne de spin.

Au moins une couche tampon peut être insérée entre l'une des électrodes et la vanne de spin.

La vanne de spin peut être simple ou duale.

La présente invention concerne aussi une tête magnétique de lecture qui comporte un dispositif magnétorésistif ainsi défini.

La présente invention concerne aussi une mémoire comprenant une matrice de points mémoire, chacun des points mémoire comportant un dispositif magnétorésistif ainsi défini.

La présente invention concerne aussi un procédé de réalisation d'un dispositif magnétorésistif à vanne de spin. Il comporte les étapes suivantes :

réalisation, pour faire la vanne de spin, d'un empilement de couches parmi lesquelles au moins deux couches magnétiques dont l'orientation relative de leur direction d'aimantation peut varier peut sous l'effet d'un champ magnétique,
réalisation de moyens pour faire circuler un courant dans la vanne de spin transversalement au plan des couches,
réalisation, dans l'une des couches magnétiques, d'au moins une couche diélectrique ou semi-conductrice discontinue avec des ponts électriquement conducteurs traversant l'épaisseur de la couche, ces derniers étant destinés à concentrer localement le courant qui circule transversalement dans l'empilement.

La couche diélectrique ou semi-conductrice avec les ponts électriquement conducteurs peut être réalisée par dépôt d'une couche mince de matériau diélectrique ou semi-conducteur incluant des particules métalliques. Ces particules métalliques se regroupent pour former les ponts.

Dans une variante, la couche diélectrique ou semi-conductrice avec les ponts électriquement conducteurs peut être réalisée en traitant localement une couche électriquement conductrice se trouvant dans l'empilement pour la rendre diélectrique ou semi-conductrice. Le traitement peut avoir lieu en cours de dépôt ou en fin de dépôt de la couche électriquement conductrice.

Dans une autre variante, la couche diélectrique ou semi-conductrice avec les ponts électriquement conducteurs peut être réalisée en plaçant une couche d'isolant ayant des discontinuités entre deux couches électriquement conductrices de l'empilement et en faisant diffuser le matériau électriquement conducteur à travers les discontinuités de la couche d'isolant. Les discontinuités peuvent exister naturellement dans la couche d'isolant ou bien être créées artificiellement dans la couche d'isolant.

Dans une autre variante, la couche diélectrique ou semi-conductrice avec les ponts électriquement conducteurs peut être réalisée en utilisant un matériau électriquement conducteur à faible mouillabilité, tel que l'argent, de manière à obtenir, lorsqu'il est déposé, une pluralité de gouttes réalisant les ponts, en déposant au-dessus un matériau électriquement conducteur, tel que l'aluminium, non miscible avec les gouttes de manière à combler les espaces entre les gouttes, et en effectuant un traitement du matériau électriquement conducteur situé entre les gouttes pour le rendre diélectrique ou semi-conducteur.

L'épaisseur du matériau électriquement conducteur est légèrement inférieure à celle des gouttes pour obtenir les ponts traversants.

Le matériau électriquement conducteur conduisant à la couche diélectrique ou semi-conductrice discontinue peut être déposé sur une des couches de l'empilement, un matériau électriquement conducteur à faible mouillabilité conduisant à une pluralité de gouttes étant déposé au-dessus, un traitement étant effectué pour rendre diélectrique ou semi-conducteur le matériau électriquement conducteur situé entre les gouttes.

Un matériau électriquement conducteur à faible mouillabilité et un matériau électriquement conducteur non miscibles peuvent être déposés en même temps sur une couche de l'empilement, et traités de manière à rendre diélectrique ou semi-conducteur le matériau électriquement conducteur.

Un matériau électriquement conducteur à faible mouillabilité conduisant à une pluralité de gouttes peut être déposé sur une des couches de l'empilement, cette couche de l'empilement étant traitée de manière à la rendre diélectrique ou semi-conducteur en surface et à assurer sa coopération avec les gouttes.

Le traitement peut être une oxydation ou une nitruration.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- la figure 1 (déjà décrite) représente en coupe un dispositif magnétorésistif de l'art connu ;
- la figure 2 représente en coupe un dispositif magnétorésistif à vanne de spin simple;
- la figure 3 représente, en vue d'expliquer son fonctionnement, une partie du dispositif magnétorésistif de la figure 2 ;
- la figure 4 représente en coupe un autre exemple d'un dispositif magnétorésistif;
- les figures 5A, 5B, 5C représentent encore d'autres exemples de dispositifs magnétorésistifs, celui de la figure 5B étant selon l'invention ;
- les figures 6 à 8 montrent plusieurs variantes de dispositifs magnétorésistifs à vanne de spin duale, celui de la figure 8 étant selon l'invention ;
- la figure 9 représente une tête magnétique de lecture incluant un dispositif magnétorésistif;
- la figure 10 représente une mémoire dont les points mémoire comportent chacun un dispositif magnétorésistif selon l'invention ;
- les figures 11A à 11C illustrent des réalisations de couches diélectriques discontinues avec des ponts électriquement conducteurs qui les traversent.

Sur ces figures, les divers éléments ne sont pas représentés à l'échelle dans un souci de clarté.

## EXPOSÉ DÉTAILLÉ DE MODES DE RÉALISATION PARTICULIERS

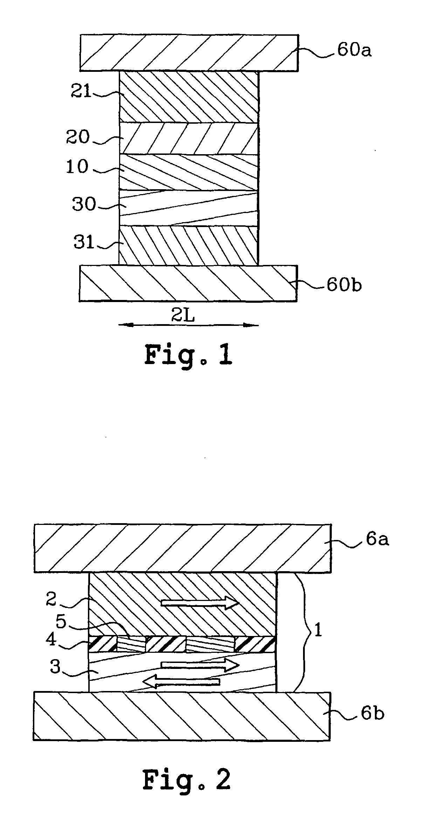

La figure 2 représente un exemple de dispositif magnétorésistif à vanne de spin selon l'invention dans une configuration de base. Comme nous l'avons vu précédemment une vanne de spin à courant perpendiculaire comporte au moins deux couches magnétiques dont l'orientation relative de leurs directions d'aimantation est susceptible de varier sous l'effet d'un champ magnétique. Au moins l'une des couches magnétiques a une direction d'aimantation libre. Pour simplifier schémas et descriptions, les exemples présentés dans la suite concernent une structure dont l'une des couches magnétiques a sa direction d'aimantation libre et dont l'autre a sa direction d'aimantation fixe. Les deux couches magnétiques auraient pu avoir leurs directions d'aimantation libres et l'adaptation de l'une des structures à l'autre se fait aisément.

Le dispositif de la figure 2 comporte une vanne de spin 1 qui est un empilement de couches avec des couches magnétiques 2, 3 parmi lesquelles au moins une couche magnétique 2 dite piégée et au moins une couche magnétique 3 dite libre et au sein de l'empilement 1, au moins une couche diélectrique ou semi-conductrice 4, traversée par des ponts 5 électriquement conducteurs, orientés transversalement au plan des couches magnétiques 2, 3. Il est préférable que la couche 4 diélectrique ou semi-conductrice qui est discontinue à cause de la présence des ponts 5, se situe à l'interface entre les deux couches magnétiques 2, 3.

L'aimantation de la couche magnétique dite piégée 2 (une seule flèche) a une direction fixe. L'aimantation de la couche magnétique dite libre 3 (deux flèches opposées) peut s'orienter librement dans un champ magnétique dans lequel elle est plongée et que l'on cherche à détecter dans l'application des têtes magnétiques de lecture. La variation relative d'orientation de la direction d'aimantation des deux couches magnétiques 2, 3 conduit à un changement de résistance électrique de la vanne de spin. Le dispositif magnétorésistif comporte de plus des moyens 6a, 6b pour faire circuler un courant électrique dans la vanne de spin, au travers de l'empilement 1, ces moyens pouvant comprendre deux électrodes 6a, 6b qui bornent la vanne de spin 1. Les électrodes 6a, 6b servent aussi de prise de tension pour une mesure de la variation de résistance. Les couches magnétiques 2, 3 sont alors conductrices de l'électricité.

Les ponts conducteurs 5 associés à la couche diélectrique ou semi-conductrice 4 ont une fonction de concentration du courant circulant dans l'empilement 1. Ils connectent électriquement les deux couches magnétiques 2, 3. Ils conservent, sur la durée de la traversée, le spin des électrons qui les empruntent. La longueur de diffusion de spin est supérieure à la distance séparant les deux couches.

La couche diélectrique ou semi-conductrice 4 discontinue a pour principal rôle d'assurer une isolation électrique localisée entre les deux couches magnétiques 2, 3 qui sont électriquement conductrices. Elle peut également avoir un rôle d'isolation magnétique entre les deux couches magnétiques 2, 3 et dans ce cas est amagnétique. Son épaisseur peut être de l'ordre de 0,2 à 5 nm.

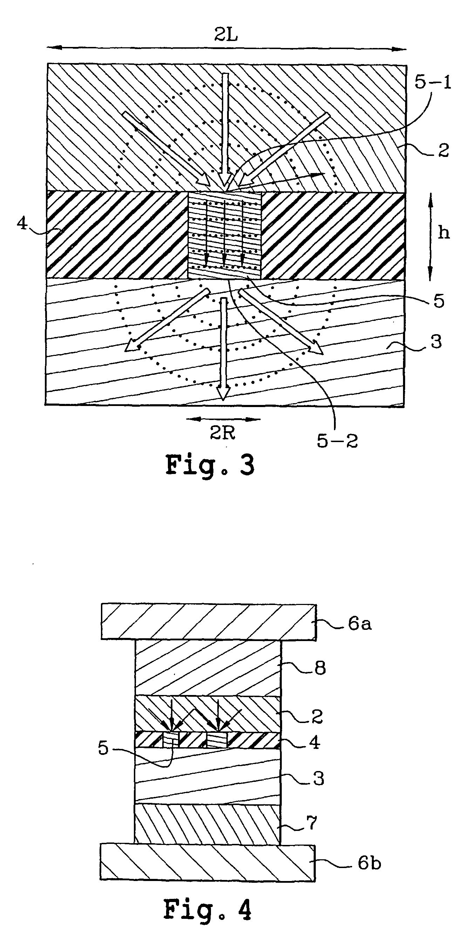

Le principe de l'obtention d'une forte valeur de résistance tout en conservant une forte amplitude de magnétorésistance par rapport aux dispositifs de l'art antérieur, est illustré sur la figure 3 qui montre un détail partiel de la vanne de spin du dispositif représenté à la figure 2.

Sur la figure 4 à laquelle, on va également se référer, on a représenté un exemple de dispositif qui va servir à faire une comparaison avec la figure 1. Comme sur la figure 1, ont été ajoutées sur la figure 4 une couche tampon 7 et une couche antiferromagnétique 8. La couche tampon 7 peut être réalisée en tantale ou en alliage NiFeCr par exemple. La couche antiferromagnétique peut être réalisée à base de manganèse par exemple à base PtMn, PdPtMn, PtMnCr, IrMn, FeMn, NiMn, RuRhMn.

Le courant qui circule perpendiculairement aux couches magnétiques 2, 3 se concentre au niveau des ponts électriquement conducteurs 5. Ces ponts 5 dont la taille est petite, peuvent être assimilés à des puits et des sources ponctuelles de courant. Ces ponts 5 peuvent avoir quelques nanomètres de diamètre si la vanne de spin a une surface de quelques centièmes de $\mu m^2$. Les lignes de courant qui prennent naissance dans les couches magnétiques 2, 3 et au travers des ponts 5 conducteurs sont représentées en traits pleins.

Dans les couches magnétiques 2, 3 les lignes isopotentielles, illustrées par les traits pointillés, prennent la forme de demi-sphères concentriques dont l'équateur se trouve au niveau de la couche 4 diélectrique ou semi-conductrice traversée par les ponts 5 électriquement conducteurs.

Si le courant circulant dans la vanne de spin vaut I, la densité de courant à une distance r d'une première extrémité 5-1 d'un des ponts 5 est :

$$J = I/2\pi.r^2$$

et le champ électrique local vaut :

$$E = \rho_F.J$$

$E = \rho_F.I/2\pi. r^2$ avec $\rho_F$ résistivité du matériau magnétique de la couche magnétique 2 jouxtant la première extrémité 5-1 du pont 5.

La différence de potentiel entre une partie très éloignée de la première extrémité 5-1 du pont 5, par exemple l'électrode 6a qui se trouve au-delà de la couche magnétique 2 qui jouxte la première extrémité 5-1 du pont 5, vaut :

$V_\infty - V_{5-1} = \rho_F.I/2\pi.R$ avec R rayon du pont 5 qui est supposé, dans l'exemple, cylindrique.

A l'intérieur du pont 5, les lignes de courant sont parallèles à l'axe du cylindre. La différence de potentiel entre les deux extrémités 5-1, 5-2 du pont 5 est donnée par :

$V_{5-1} - V_{5-2} = \rho_P.h.I/\pi.R^2$ avec $\rho_P$ résistivité du pont 5 et h hauteur du pont 5.

De la même manière entre la seconde extrémité 5-2 du pont 5 et une partie très éloignée de cette extrémité, par exemple l'électrode 6b qui se trouve au-delà de la couche magnétique 3 qui jouxte la seconde extrémité 5-2 du pont 5, la différence de potentielle est donnée par :

$V_{5-2} - V_{-\infty} = \rho_{F'}.I/2\pi.R$ avec $\rho_F$, résistivité du matériau magnétique de la couche magnétique 3 jouxtant la seconde extrémité 5-2 du pont 5.

La différence de potentiel entre les deux électrodes 6a, 6b qui encadrent la vanne de spin est donnée par :

$$V_{\infty} - V_{-\infty} = (\rho_{F.}\ I/2\pi.R) + (\rho_P.h.I/\pi.R^2) +$$

$$(\rho_{F'}.I/2\pi.R)$$

La résistance entre les deux électrodes 6a, 6b est donnée par :

$$R_{CPP} = (V_{\infty} - V_{-\infty})/I$$

$$R_{CPP} = (\rho_F/2\pi.R) + (\rho_P.h/\pi.R^2) + (\rho_{F'}/2\pi.R)$$

En comparaison, dans une vanne de spin classique entièrement métallique telle que celle de la figure 1, dans laquelle la couche séparant les couches magnétiques est une couche électriquement conductrice amagnétique, de même résistivité que celle du matériau des ponts ($\rho_P$), la résistance serait donnée par :

$$R_{CPP'} = (\rho_F.e/\pi.L^2) + (\rho_P.I/\pi.L^2) + (\rho_{F'}.e'/2\pi.L^2)$$

où e et e' représentent les épaisseurs des couches magnétiques 20, 30, l l'épaisseur de la couche séparatrice 10 et L le rayon de la vanne de spin qui est supposée cylindrique.

L'accroissement de la résistance liée au remplacement de la couche séparatrice 10 par la couche diélectrique ou semi-conductrice 4 discontinue avec les ponts électriquement conducteurs 5, est de l'ordre de :

$R_{CPP}/R_{CPP'} \approx L^2/e.R$ en considérant que e, l et e' sont sensiblement les mêmes.

Par exemple, pour une épaisseur de couche magnétique e de l'ordre de 10 nm, un rayon L de la vanne de spin de l'ordre de 100 nm, un rayon R de pont 5 de l'ordre de 2nm, on peut obtenir un accroissement de la résistance de l'ordre de 500, ce qui permet au produit RA d'atteindre des niveaux de l'ordre de 1 $\Omega.\mu m^2$, ce qui est tout à fait satisfaisant.

La résistance du pont 5 est de l'ordre de 30 $\Omega$ avec les dimensions énumérées plus haut.

L'amplitude de la magnétorésistance est plus élevée dans l'exemple de la figure 4 que dans l'exemple de la figure 1. En effet, la densité de courant et donc la variation de tension est maximale à la séparation entre les couches magnétiques, au niveau des ponts électriquement conducteurs 5, or c'est dans ce voisinage que prend naissance la magnétorésistance. Si l'empilement comprend, en plus, d'autres couches comme la couche tampon 7 et la couche antiferromagnétique 8, l'addition de ces couches en série ne réduit que très peu l'effet de magnétorésistance car la tension aux bornes de ces couches sera faible, elles sont traversées par une faible densité de courant. Au contraire, dans l'exemple de la figure 1, les lignes de courant restent toujours perpendiculaires aux interfaces et la magnétorésistance est fortement réduite par l'addition de ces couches supplémentaires. La résistance de ces couches s'ajoute à la résistance des couches magnétiques ce qui a pour effet de diluer la magnétorésistance et d'en réduire l'amplitude. Une estimation du gain en magnétorésistance effective résultant de la suppression de cette dilution par la constriction des lignes de courant grâce à la présence des ponts électriquement conducteurs est présentée dans les tableaux suivants :

**EXEMPLE DE LA FIGURE 1**

|  | Résistivité $\rho$ en $\mu.\Omega.cm$ | Epaisseur e en nm | Résistance Rc en $\Omega$ |
|---|---|---|---|
| couche 21 | 150 | 15 | 2,25 |
| couche 20 | 20 | 3 | 0,06 |
| couche 10 | 5 | 2 | 0,01 |
| couche 30 | 20 | 5 | 0,1 |
| couche 31 | 80 | 5 | 0,4 |

**EXEMPLE DE LA FIGURE 4**

|  | Résistivité $\rho$ en $\mu.\Omega.cm$ | Epaisseur e en nm | Résistance Rc en $\Omega$ |
|---|---|---|---|
| couche 8 | $\approx 150$ | 15 | 2,25 |
| couche 2 | $\approx 20$ | 3 | $\approx 15$ |
| couche 4+5 | $\approx 5$ | 2 | 8 |
| couche 3 | $\approx 20$ | 5 | 15 |
| couche 7 | $\approx 80$ | 5 | 0,4 |

|  | Exemple figure 1 | Exemple figure 4 |
|---|---|---|
| $R_{ut}$ résistance de la partie utile pour la magnétorésistance | $0,17\Omega$ | $38\Omega$ |
| $R_T$ : résistance totale | $2,82\Omega$ | $41\Omega$ |
| magnétorésistance intrinsèque = $R_{ut}/ R_T$ | $0,06\Omega$ | $0,92\Omega$ |
| magnétorésistance effective = 40% de la magnétorésistance intrinsèque | 2,4% | 37% |

Ce gain peut atteindre au moins 10. Les résistances obtenues peuvent être ajustées en jouant sur la taille et la densité des ponts électriquement conducteurs et se situer par exemple dans la gamme $0,1\ \Omega.\mu m^2$ à $1\ \Omega.\mu m^2$.

Les ponts 5 peuvent être réalisés à base d'un métal amagnétique, on peut utiliser un métal noble choisi dans le groupe comprenant l'or, l'argent, le cuivre ou leurs alliages.

Dans l'exemple de la figure 4, la couche diélectrique ou semi-conductrice 4 discontinue est amagnétique.

La couche 4 peut être réalisée à base d'un oxyde tel que par exemple l'alumine, la zircone, le titanate de strontium ($SrTiO_3$), l'oxyde de magnésium, l'oxyde de cobalt, l'oxyde de nickel, l'oxyde de fer ($Fe_2O_3$) et/ou d'un nitrure tel que le nitrure d'aluminium ou d'un matériau semi-conducteur tel que le germanium, le silicium, l'arséniure de gallium. Les oxydes et les nitrures possèdent de meilleures propriétés magnétorésistives que les matériaux semiconducteurs.

Dans une variante, les ponts 5 peuvent être réalisés dans un matériau électriquement conducteur magnétique tel que le cobalt par exemple. Ce matériau peut être différent de celui des couches magnétiques 2,3. La différence par rapport à la situation précédente dans laquelle les ponts sont en matériau amagnétique, est qu'un couplage magnétique existera entre les deux couches magnétiques 2, 3. Lorsque les aimantations des deux couches 2, 3 sont antiparallèles, une paroi parallèle au plan des couches se formera et restera confinée à l'intérieur des ponts 5 magnétiques, elle sépare des zones ayant des sens d'aimantation opposés.

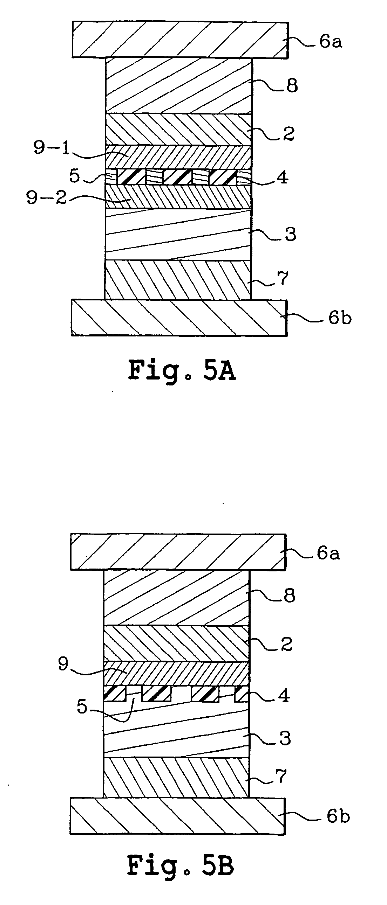

Il est possible d'insérer au moins une couche séparatrice 9-1, 9-2 continue amagnétique électriquement conductrice entre la couche diélectrique ou semi-conductrice 4 avec ses ponts 5 électriquement conducteurs et les couches magnétiques 2, 3 pour effectuer un découplage magnétique. Sur la figure 5A, qui illustre cette configuration, les deux couches magnétiques 2, 3 prennent en sandwich un empilement formé de deux couches séparatrices électriquement conductrices 9-1, 9-2 encadrant une couche diélectrique ou semi-conductrice 4 avec les ponts 5 électriquement conducteurs.

Le matériau diélectrique ou semi-conducteur de la couche discontinue 4 peut être magnétique par exemple en oxyde de cobalt ou en oxyde de fer cobalt ou en spinelle ferromagnétique $Fe_3O_4$. Il peut aussi être amagnétique par exemple en $Al_2O_3$, $SiO_2$, $HfO_2$, $Ta_2O_5$.

On aurait pu envisager avec la structure de la figure 5A que le matériau électriquement conducteur des ponts 5 soit celui des couches séparatrices 9-1, 9-2, il aurait pu diffuser à travers des discontinuités de la couche en matériau diélectrique 4.

Il est également possible que le matériau des ponts 5 soit celui de l'une des couches magnétiques 2, 3. On se réfère à la figure 5B qui présente ce cas particulier. On peut alors placer la couche diélectrique ou semi-conductrice avec ses ponts électriquement conducteurs à l'intérieur de l'une des couches magnétiques. Sur la figure 5B, elle est très légèrement à l'intérieur de la couche magnétique libre 3, elle se trouve du côté de l'autre couche magnétique 2.

Les deux couches magnétiques 2, 3 sont séparées par au moins une couche séparatrice 9 continue en matériau électriquement conducteur amagnétique, par exemple en cuivre. Cela revient à dire que la couche diélectrique ou semi-conductrice 4 avec ses ponts électriquement conducteurs 5 est à l'interface entre la couche magnétique qui l'accueille 3 et la couche séparatrice 9.

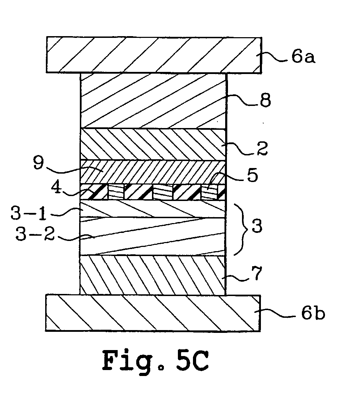

Il est possible que l'une des couches magnétiques soit formée d'un empilement de plusieurs couches intermédiaires. Sur la figure 5C, il s'agit de la couche magnétique libre 3. Les couches intermédiaires 3-1, 3-2 en matériaux différents renforcent l'amplitude de magnétorésistance géante en augmentant le contraste de diffusion dépendante du spin et en réduisant les fluctuations magnétiques aux interfaces à température ambiante. L'une des couches intermédiaires 3-2 dite sensible peut être réalisée par exemple en Ni80Fe20 et l'autre 3-1, dénommée couche intermédiaire magnétique de dopage interfacial, la plus proche de la couche magnétique piégée 2, peut être par exemple en Co90Fe10. La couche diélectrique discontinue 4 avec les ponts électriquement conducteurs 5 est à l'interface entre la couche 3-1 de dopage interfacial et l'autre couche magnétique 2 mais elle pourrait aussi être incluse dans la couche 3-1 de dopage interfacial. De manière générale, la couche diélectrique ou semi-conductrice discontinue 4 est placée avantageusement le plus près possible de l'autre couche magnétique 2.

Dans cet exemple également une couche séparatrice magnétique 9 est insérée entre la couche diélectrique ou semi-conductrice discontinue 4 avec les ponts électriquement conducteurs et l'autre couche magnétique 2. On suppose que la couche 4 est magnétique.

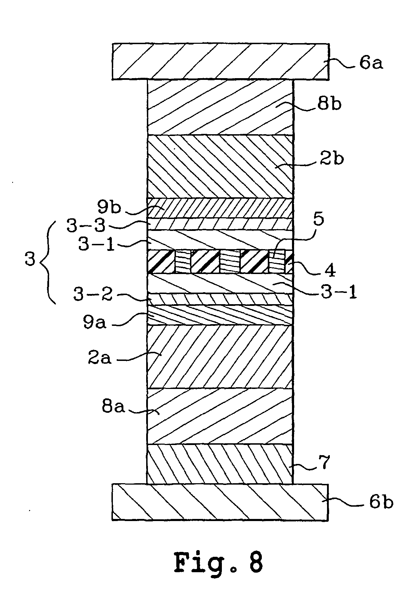

Sur la figure 8 qui représente une variante d'un dispositif selon l'invention avec une paire de vannes de spin en série, la couche diélectrique ou semi-conductrice avec ses ponts électriquement conducteurs se trouve au sein de la couche magnétique libre et non plus en surface.

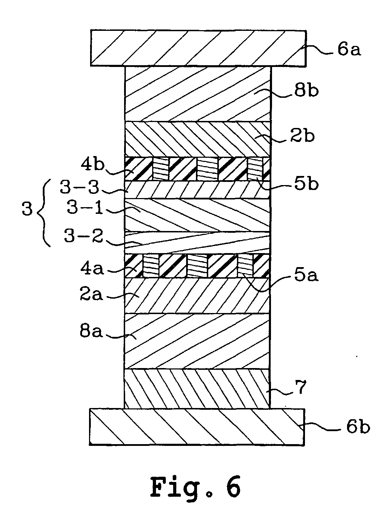

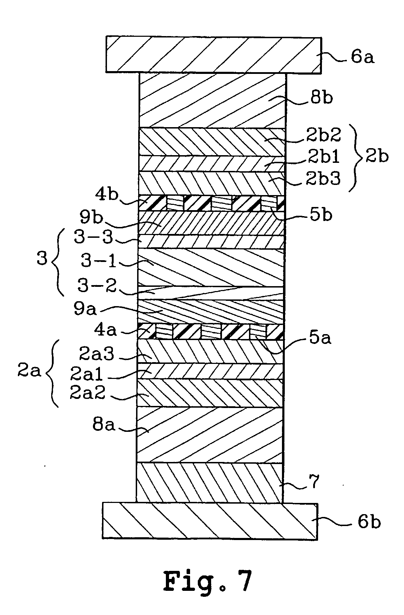

Il est toutefois préférable de placer la couche diélectrique ou semi-conductrice 4 avec ses ponts électriquement conducteurs 5 du côté de la couche magnétique piégée 2 pour ne pas nuire à la forte susceptibilité que doit avoir la couche magnétique libre 3. Cette configuration est illustrée sur les figures 6 et 7 qui montrent encore des dispositifs avec une paire de vannes de spin en série.

On s'arrange pour placer la couche diélectrique ou semi-conductrice 4 avec ses ponts électriquement conducteurs 5 le plus près possible de l'interface entre les couches magnétiques 3, 2, car sinon l'effet de concentration de courant à la source de magnétorésistance serait réduit et l'amplitude de la magnétorésistance également.

La couche magnétique piégée 2a, 2b peut être formée d'un empilement de trois couches intermédiaires. On peut la réaliser, comme sur la figure 7, avec deux couches intermédiaires magnétiques piégées (2a2, 2a3), (2b2, 2b3) prenant en sandwich une couche intermédiaire électriquement conductrice amagnétique 2a1, 2b1. On peut par exemple utiliser un empilement CoFe/Ru/CoFe. D'autres matériaux que le ruthénium sont possibles tels que Ir, Rh, Re.

L'épaisseur de la couche intermédiaire centrale 2a1, 2b1 peut être comprise entre environ 0,3 et 1 nm. On réalise ainsi une couche piégée dite synthétique. Une telle couche piégée synthétique permet d'augmenter le champ de piégeage et de renforcer sa stabilité magnétique.

On va voir maintenant plusieurs exemples de dispositifs magnétorésistifs avec une paire de vannes de spin en série, cette structure étant connue sous la dénomination de vanne de spin duale. Une telle vanne de spin duale peut comporter : une couche magnétique libre centrale 3 et deux couches magnétiques piégées 2a, 2b de part et d'autre de la couche magnétique libre 3. L'empilement correspondant à la vanne de spin duale de la figure 6 comporte une couche tampon 7 au-dessus de l'une des électrodes 6b dite électrode de base 6b, une première couche antiferromagnétique de piégeage 8a, une première couche piégée 2a, une première couche diélectrique ou semi-conductrice discontinue 4a avec des ponts 5a électriquement conducteurs, une couche magnétique libre 3, une seconde couche diélectrique ou semi-conductrice discontinue 4b avec des ponts 5b électriquement conducteurs, une seconde couche magnétique piégée 2b, une seconde couche antiferromagnétique de piégeage 8b et enfin la seconde électrode 6a dite électrode de sommet. Dans cette configuration, les deux couches diélectriques ou semiconductrices 4a, 4b discontinues avec des ponts 5a, 5b électriquement conducteurs ont la même structure que sur la figure 4. Quant à la couche magnétique libre 3, elle est formée d'un empilement de couches intermédiaires avec deux couches intermédiaires magnétiques de dopage interfacial 3-2, 3-3 prenant en sandwich une couche intermédiaire magnétique 3-1 libre proprement dite.

EP 1 435 101 B1

On s'intéresse maintenant à la figure 7. L'empilement correspondant à la vanne de spin duale de la figure 7 comporte une couche tampon 7 au-dessus de l'une des électrodes 6b dite électrode de base 6b, une première couche antiferromagnétique de piégeage 8a, une première couche piégée 2a synthétique, une première couche diélectrique ou semi-conductrice discontinue 4a avec des ponts 5a électriquement conducteurs, une première couche séparatrice électriquement conductrice amagnétique 9a, une couche magnétique libre 3, une seconde couche séparatrice électriquement conductrice amagnétique 9b, une seconde couche diélectrique ou semi-conductrice discontinue 4b avec des ponts 5b électriquement conducteurs, une seconde couche piégée 2b synthétique, une seconde couche antiferromagnétique de piégeage 8b et enfin la seconde électrode 6a dite électrode de sommet.

Dans cette configuration, chacune des couches piégées 2a, 2b est synthétique et formée d'un empilement de couches intermédiaires avec une couche intermédiaire électriquement conductrice amagnétique 2a1, 2b1 prise en sandwich entre deux couches magnétiques de piégeage (2a2, 2a3), (2b2, 2b3).

Quant à la couche libre 3, elle est similaire à celle de la figure 6 avec deux couches intermédiaires magnétiques de dopage interfacial 3-2, 3-3 prenant en sandwich une couche intermédiaire magnétique 3-1 libre proprement dite.

On se réfère maintenant à la figure 8. L'empilement correspondant à la vanne de spin duale de la figure 8 comporte une couche tampon 7 au-dessus de l'une des électrodes 6b dite électrode de base, une première couche antiferromagnétique de piégeage 8a, une première couche piégée 2a, une première couche séparatrice 9a en matériau électriquement conducteur amagnétique, une couche magnétique libre 3 incluant la couche diélectrique ou semi-conductrice discontinue 4 avec des ponts 5 électriquement conducteurs, une seconde couche séparatrice 9b électriquement conductrice amagnétique, une seconde couche piégée 2b, une seconde couche antiferromagnétique de piégeage 8b et enfin la seconde électrode 6a dite électrode de sommet.

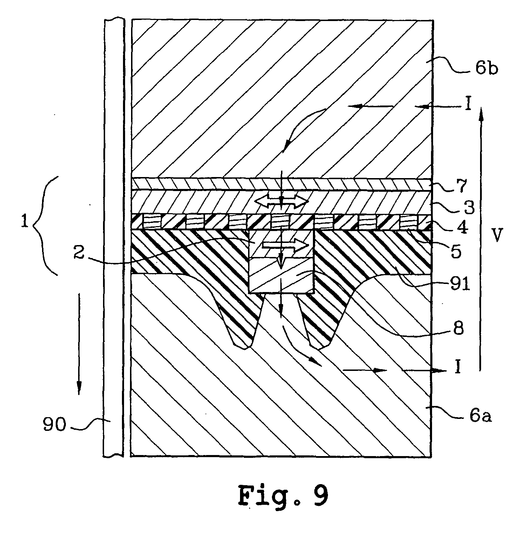

La figure 9 montre un exemple de tête magnétique incluant un dispositif magnétorésistif ainsi décrit avec une vanne de spin. Les électrodes 6a, 6b d'amenée de courant I et de prise de tension V servent d'écrans magnétiques. La vanne de spin 1 vient se positionner à proximité d'un support magnétique mobile 90, des données sous forme de bits à lire étant enregistrées sur ce support. Les écrans magnétiques permettent à la vanne de spin de détecter des transitions magnétiques individuelles, entre deux bits successifs, sans interférence avec les transitions voisines. La couche magnétique piégée 2 et la couche antiferromagnétique de piégeage 8 ont une surface inférieure à celle de la couche diélectrique 4 avec les ponts 5 électriquement conducteurs qui lui est en vis à vis. Elles sont enrobées de matériau diélectrique 91 qui s'étend le long de la couche discontinue 4 avec les ponts électriquement conducteurs 5. Cette structure permet d'éloigner la zone où passe le courant de la surface du support magnétique 90.

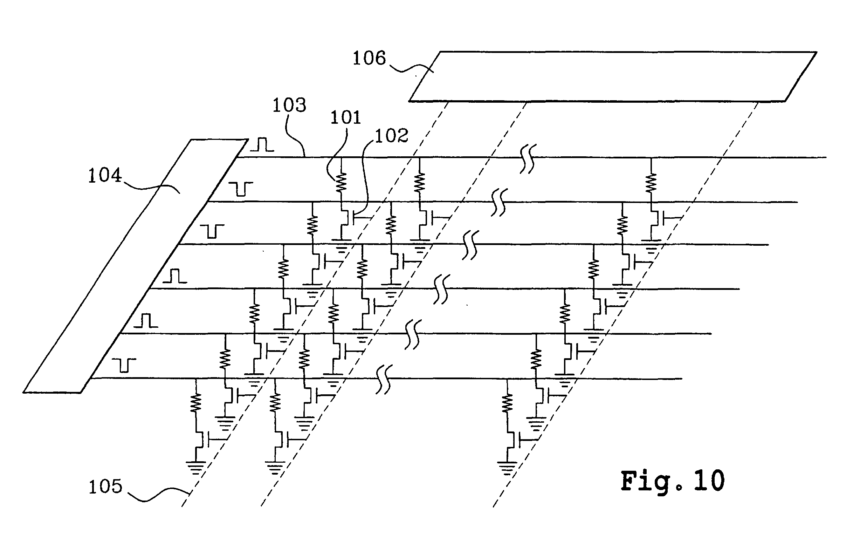

Sur la figure 10 on a représenté une mémoire selon l'invention. Elle comprend une matrice de points mémoires adressables par lignes et colonnes. Chaque point mémoire comprend un dispositif 101 selon l'invention, illustré par une résistance, en série avec un moyen de commutation 102, prenant la forme d'un transistor. Chaque dispositif selon l'invention est relié à une ligne d'adressage 103 et le moyen de commutation à une colonne d'adressage 105. Les lignes d'adressage 103 sont reliées aux sorties d'un circuit d'adressage ligne 104, et les colonnes d'adressage 105 aux sorties d'un circuit d'adressage colonne 106.

On va voir maintenant un procédé de réalisation d'une couche diélectrique ou semi-conductrice avec des ponts électriquement conducteurs, ces ponts étant transversaux au plan de la couche. Une telle couche est telle que celle représentée avec les références 4, 5 sur les figures 2 à 8.

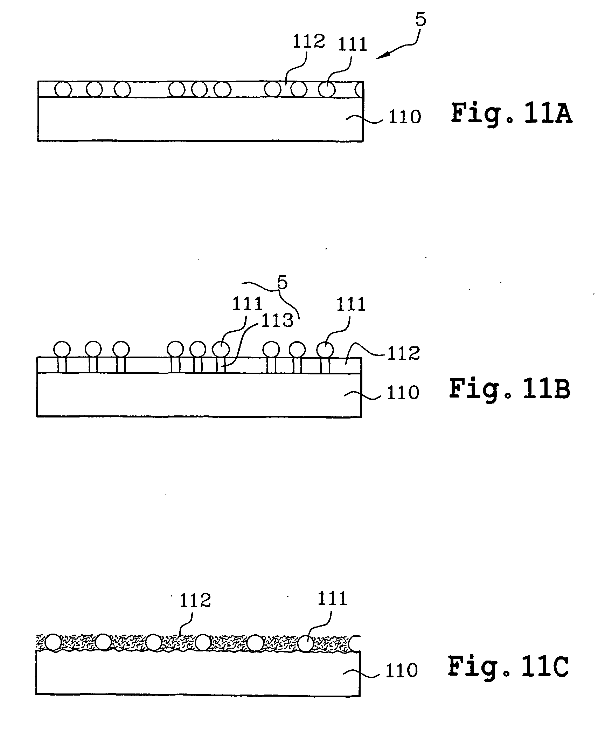

On se réfère à la figure 11A. On part d'un support 110 et on utilise pour réaliser les ponts un matériau électriquement conducteur qui, en couche mince, a une faible mouillabilité à la surface du support 110. Le support peut être un matériau magnétique tel que le NiFe, le Co, le CoFe, notamment dans le cas où l'on réaliserait des dispositifs magnétorésistifs. Ce matériau, lorsqu'il est déposé à la surface du support, se regroupe en une multitude de petites gouttes 111. On rappelle qu'un film mince mouillant s'étale sur un solide en occupant la surface la plus grande possible. Au contraire, un film mince à faible mouillabilité occupera une surface faible à la surface du solide. C'est cette propriété qui est utilisée pour réaliser les ponts.

Il suffit d'associer ce matériau à faible mouillabilité avec le matériau diélectrique ou semi-conducteur 112 qui forme la couche discontinue.

Le matériau utilisé pour réaliser les ponts peut être de l'argent qui est déposé sous forme de couche mince par exemple par dépôt physique en phase vapeur (connu sous l'abréviation PVD pour la dénomination anglaise "Physical Vapor Deposition"). L'argent est très peu mouillant à température ambiante et encore moins mouillant à la chaleur. En déposant une très fine couche d'argent à la surface du support 110, d'épaisseur de l'ordre de 0, 2 nm, il va se former des gouttes 111 d'argent de diamètre de l'ordre de 1 à 2 nm environ. D'autres matériaux que l'argent peuvent être employé par exemple le cuivre ou l'or mais cet effet de faible mouillabilité est moins prononcé.

Pour réaliser la couche discontinue diélectrique ou semi-conductrice 112, on peut déposer un matériau conducteur, non miscible avec les gouttes 111 d'argent, rendu diélectrique ou semi-conducteur après un traitement, le traitement n'ayant pratiquement pas d'influence sur les gouttes d'argent.

On peut dans cette optique déposer de l'aluminium par PVD par exemple, avec une épaisseur moindre que celle des gouttes 111 d'argent. L'aluminium va combler l'espace autour des gouttes 111 d'argent. Après un traitement tel qu'une oxydation ou une nitruration, l'aluminium va se transformer en alumine ou en nitrure d'aluminium et devenir diélectrique. L'oxydation peut être une oxydation naturelle, une oxydation par plasma d'oxygène, par source d'oxygène atomique, etc. Comme l'aluminium est facilement oxydable alors que l'argent ne l'est pas car c'est un métal noble, seul l'aluminium s'oxydera en alumine. On obtient une couche d'alumine 112 d'environ 2nm avec des ponts 111.

Si l'on veut continuer à réaliser un dispositif magnétorésistif, on peut ensuite déposer une autre couche magnétique au-dessus.

Au lieu de déposer d'abord les gouttes 111 d'argent sur le support 110, il est possible de déposer d'abord une fine couche d'un matériau devant conduire à la couche discontinue diélectrique ou semi-conductrice 112. On peut par exemple déposer une couche d'aluminium, puis les gouttes 111 d'argent sur la fine couche d'aluminium. En effectuant une oxydation en surface, l'aluminium se situant autour des gouttes se transforme en alumine 112, l'aluminium 113 se trouvant sous les gouttes 111 d'argent n'est pas oxydé ou peu car protégé. Un pont 5 est alors formé d'une goutte 111 d'argent et de l'aluminium 113 se trouvant sous la goutte 111. La surface d'alumine 112 risque d'être plus rugueuse que dans le cas précédent.

Une autre de variante est de codéposer en même temps le matériau conduisant à la couche diélectrique ou semi-conductrice et le matériau électriquement conducteur formant les gouttes. Cela conduit à un alliage hétérogène. Lorsqu'il est déposé à la surface du support 110, les gouttes se forment à la surface du support, les deux matériaux codéposés n'étant pas miscibles. En effectuant un traitement par exemple une oxydation ou une nitruration de surface, la couche diélectrique ou semi-conductrice 112 se forme autour des gouttes 111 que l'on suppose en argent.

Une autre méthode est de déposer le matériau électriquement conducteur à faible mouillabilité directement sur un support 110, et c'est ce support qui va, par traitement, être rendu diélectrique ou semi-conducteur en surface et donner la couche discontinue. Dans l'exemple du dispositif magnétorésistif objet de l'invention, le support 110 peut être magnétique en Co ou en CoFe. Il peut s'agir de la couche intermédiaire magnétique de dopage interfacial décrite à la figure 5B. En oxydant directement cette couche intermédiaire, on obtient une étendue d'oxyde CoO ou CoFeO qui vient coopérer avec les gouttes 111. La surface du support 110, lorsqu'elle est oxydée s'épaissit légèrement entre les gouttes d'argent.

Pour réaliser un dispositif selon l'invention avec au moins une vanne de spin, on va déposer successivement les couches de l'empilement. Toutes les techniques de dépôt connues de l'homme de l'art pour réaliser les couches magnétiques qu'elles soient formées d'un empilement de couches intermédiaires ou non, les éventuelles couches séparatrices, la couche tampon, une ou plusieurs couches antiferromagnétiques, peuvent être employées. Il s'agit notamment des techniques de pulvérisation cathodique, dépôt par faisceau d'ions, épitaxie par jet moléculaire voire électrodéposition. La partie la plus critique est l'élaboration de la couche diélectrique ou semi-conductrice discontinue avec les ponts électriquement conducteurs.

On peut bien sûr employer toutes les méthodes décrites précédemment pour réaliser la couche diélectrique discontinue avec les ponts électriquement conducteurs mais d'autres encore sont possibles.

On peut réaliser une couche mince en matériau diélectrique ou semi-conducteur, par exemple en alumine ou en silice, contenant des particules solides, métalliques amagnétiques (par exemple du groupe des métaux nobles tels que l'argent, l'or, le cuivre ou leurs alliages) ou magnétiques tel le cobalt ou ses alliages. En chauffant le support sur lequel la couche mince est déposée on favorise la mobilité atomique des particules métalliques qui se regroupent pour former les ponts électriquement conducteurs. On peut aussi effectuer un ou plusieurs recuits afin d'obtenir les ponts souhaités. Dans ce cas, le support qui reçoit la couche mince est soit l'une des couches magnétiques, soit une couche séparatrice.

Le dépôt de la couche mince de diélectrique peut être réalisé par PVD à partir d'une cible en matériau diélectrique ou par pulvérisation réactive d'une cible en matériau métallique sous atmosphère oxydante.

Les particules solides peuvent aussi être déposées directement sous forme d'agregats, ou clusters métalliques à partir d'une source d'agregats de métaux nobles.

Une autre méthode peut être d'oxyder localement une couche en matériau électriquement conducteur pour la rendre diélectrique localement. Les endroits non oxydés forment les ponts électriquement conducteurs. Cette couche peut être une des couches magnétiques ou bien une couche séparatrice ou bien une couche déposée à cet effet. L'oxydation peut se faire une fois la couche déposée ou en cours de dépôt. Dans cette optique, on interrompt le dépôt, on effectue l'oxydation puis on reprend le dépôt.

Une autre méthode utilise le fait que lorsqu'une couche d'oxyde avec des discontinuités est prise en sandwich entre deux couches métalliques, du métal diffuse à travers les discontinuités. Ces discontinuités sont des défauts ou joints de grains. La couche d'oxyde peut comporter naturellement des discontinuités, il peut s'agir notamment d'une couche ultra mince d'oxydes nanocristallisés comme par exemple, les oxydes de magnésium (MgO), d'hafnium (HfO$_2$), de tantale (Ta$_2$O$_5$), de cobalt (CoO), de nickel (NiO), de cuivre (cuO). Il suffit de déposer la couche d'oxydes sur un support métallique, que ce soit l'une des couches magnétiques 2, 3, l'une des couches intermédiaires magnétiques 3-1, 3-2, ou une couche séparatrice 9 électriquement conductrice amagnétique. Le dépôt peut se faire à partir d'une cible d'oxyde ou par pulvérisation réactive ou en déposant une couche métallique et en l'oxydant ensuite. On la recouvre d'une couche métallique, que ce soit l'une des couches magnétiques 2, 3, l'une des couches intermédiaires magnétiques 3-1, 3-2, ou couche séparatrice 9 électriquement conductrice amagnétique. Les ponts électriquement conducteurs se forment alors naturellement.

Les discontinuités dans la couche d'oxyde au lieu d'être naturelles peuvent être créés par des techniques de la microélectronique, par exemple par un faisceau ionique focalisé.

Bien que plusieurs modes de réalisation de la présente invention aient été représentés et décrits de façon détaillée, on comprendra que différents changements et modifications puissent être apportés sans sortir du cadre de l'invention.

**Revendications**

1. Dispositif magnétorésistif à vanne de spin (1) formée d'un empilement de couches parmi lesquelles au moins deux couches magnétiques (2, 3) dont l'orientation relative de leurs directions d'aimantation peut varier sous l'influence d'un champ magnétique et au moins une couche diélectrique ou semi-conductrice (4) discontinue avec des ponts (5) électriquement conducteurs qui traversent l'épaisseur de la couche diélectrique ou semi-conductrice, ces derniers (5) étant destinés à concentrer localement le courant qui circule transversalement dans l'empilement, comportant des moyens (6a, 6b) pour faire circuler un courant dans la vanne de spin transversalement au plan des couches, **caractérisé en ce que** la couche (4) diélectrique ou semi-conductrice avec les ponts (5) électriquement conducteurs est disposée dans l'une des couches magnétiques (3).

2. Dispositif magnétorésistif selon la revendication 1, **caractérisé en ce qu'**une couche séparatrice (9) continue électriquement conductrice, amagnétique est insérée entre la couche (4) diélectrique ou semi-conductrice avec les ponts (5) électriquement conducteurs et l'une au moins des couches magnétiques (2, 3).

3. Dispositif magnétorésistif selon l'une des revendications 1 ou 2, **caractérisé en ce que** les ponts (5) sont réalisés dans le matériau de la couche magnétique (3) accueillant la couche (4) diélectrique ou semi-conductrice.

4. Dispositif magnétorésistif selon l'une des revendications 1 ou 2, **caractérisé en ce que** les ponts (5) électriquement conducteurs sont réalisés dans un matériau amagnétique choisi parmi les métaux nobles tels que l'or, l'argent, le cuivre ou leurs alliages.

5. Dispositif magnétorésistif selon l'une des revendications 1 à 3, **caractérisé en ce que** les ponts (5) électriquement conducteurs sont réalisés dans un matériau magnétique tel que le cobalt, le fer, le nickel ou leurs alliages.

6. Dispositif magnétorésistif selon l'une des revendications 1 à 5, **caractérisé en ce que** le matériau diélectrique ou semi-conducteur de la couche discontinue (4) est magnétique.

7. Dispositif magnétorésistif selon l'une des revendications 1 à 5, **caractérisé en que** le matériau diélectrique ou semi-conducteur de la couche discontinue (4) est amagnétique.

8. Dispositif magnétorésistif selon l'une des revendications 1 à 7, **caractérisé en ce qu'**au moins l'une des couches magnétiques (2a) est formée d'un empilement de couches intermédiaires (2a1, 2a2, 2a3).

9. Dispositif magnétorésistif selon l'une des revendications 1 à 8, **caractérisé en ce qu'**une des couches magnétiques (2) a sa direction d'aimantation fixée par association une couche antiferromagnétique (8) disposée au-delà de la couche magnétique à direction d'aimantation fixe (2) par rapport à la couche (4) diélectrique ou semi-conductrice avec les ponts (5) électriquement conducteurs.

10. Dispositif magnétorésistif selon la revendication 9, **caractérisé en ce que** la couche magnétique (2a) à direction d'aimantation fixe est formée d'une couche intermédiaire (2a1) électriquement conductrice amagnétique encadrée par deux couches intermédiaires (2a2, 2a3) magnétiques.

11. Dispositif magnétorésistif selon l'une des revendications 1 à 10, **caractérisé en ce que** la couche (4) diélectrique ou semi-conductrice discontinue est réalisée à base d'oxyde, de nitrure, de semi-conducteur.

12. Dispositif magnétorésistif selon l'une des revendications 1 à 11, **caractérisé en ce que** les moyens pour faire circuler un courant électrique comportent deux électrodes (6a, 6b) qui prennent en sandwich la vanne de spin (1).

**13.** Dispositif magnétorésistif selon la revendication 12, **caractérisé en ce qu'**au moins une couche tampon (7) est insérée entre l'une des électrodes (6b) et la vanne de spin (1).

**14.** Dispositif magnétorésistif selon l'une des revendications 1 à 13, **caractérisé en ce que** la vanne de spin (1) est duale.

**15.** Tête magnétique de lecture, **caractérisée en ce qu'**elle comporte un dispositif magnétorésistif selon l'une des revendications 1 à 14.

**16.** Mémoire comprenant une matrice de points mémoire adressable par des lignes (103) et des colonnes (105), **caractérisée en ce que** chaque point mémoire est formé d'un dispositif magnétorésistif (101) selon l'une des revendications 1 à 14 coopérant avec un moyen de commutation de courant (102).

**17.** Procédé de réalisation d'un dispositif magnétorésistif à vanne de spin (1) comportant les étapes suivantes :

réalisation, pour faire la vanne de spin, d'un empilement de couches (2, 3) parmi lesquelles au moins deux couches magnétiques dont l'orientation relative de leurs directions d'aimantation peut varier sous l'effet d'un champ magnétique,
réalisation de moyens (6a, 6b) pour faire circuler un courant dans la vanne de spin (1) transversalement au plan des couches,

**caractérisé en ce qu'**il comporte une étape de réalisation dans l'une des couches magnétiques (2,3) d'au moins une couche diélectrique ou semi-conductrice (4) discontinue avec des ponts (5) électriquement conducteurs traversant l'épaisseur de la couche, ces derniers (5) étant destinés à concentrer localement le courant qui circule transversalement dans l'empilement.

**18.** Procédé de réalisation selon la revendication 17, **caractérisé en ce que** la couche diélectrique ou semi-conductrice (4) avec les ponts (5) électriquement conducteurs est réalisée par dépôt d'une couche mince (4) de matériau diélectrique ou semi-conducteur incluant des particules métalliques, ces particules métalliques se regroupent pour former les ponts (5).

**19.** Procédé de réalisation selon la revendication 17, **caractérisé en ce que** la couche diélectrique ou semi-conductrice (4) avec les ponts (5) électriquement conducteurs, est réalisée en traitant localement une couche électriquement conductrice (9) se trouvant dans l'empilement pour la rendre diélectrique ou semi-conductrice.

**20.** Procédé de réalisation selon la revendication 19, **caractérisé en ce que** le traitement a lieu en cours de dépôt ou en fin de dépôt de la couche électriquement conductrice (9).

**21.** Procédé de réalisation selon la revendication 17, **caractérisé en ce que** la couche diélectrique ou semi-conductrice (4) avec les ponts (5) électriquement conducteurs est réalisée en plaçant une couche d'isolant (4) ayant des discontinuités entre deux couches électriquement conductrices (9-1, 9-2) de l'empilement et en faisant diffuser le matériau électriquement conducteur à travers les discontinuités de la couche d'isolant (4).

**22.** Procédé selon la revendication 21, **caractérisé en ce que** les discontinuités existent naturellement dans la couche d'isolant (4).

**23.** Procédé de réalisation selon la revendication 21, **caractérisé en ce que** les discontinuités sont créées artificiellement dans la couche d'isolant (4).

**24.** Procédé de réalisation selon la revendication 17, **caractérisé en ce que** la couche diélectrique ou semi-conductrice (4) avec les ponts (5) électriquement conducteurs est réalisée en utilisant un matériau électriquement conducteur à faible mouillabilité de manière à obtenir, lorsqu'il est déposé, une pluralité de gouttes (111), en déposant au-dessus un matériau électriquement conducteur (112), non miscible avec les gouttes de manière à combler les espaces entre les gouttes, en effectuant un traitement du matériau électriquement conducteur situé entre les gouttes pour le rendre diélectrique ou semi-conducteur.

**25.** Procédé de réalisation selon la revendication 24, **caractérisé en ce que** l'épaisseur du matériau électriquement conducteur (112) est légèrement inférieure à celle des gouttes (111).

**26.** Procédé de réalisation selon la revendication 17, **caractérisé en ce qu'**un matériau électriquement conducteur (112) conduisant à la couche diélectrique ou semi-conductrice discontinue est déposé sur une des couches de l'empilement (110), un matériau électriquement conducteur à faible mouillabilité (111) conduisant à une pluralité de gouttes étant déposé au-dessus, un traitement étant effectué pour rendre diélectrique ou semi-conducteur le matériau électriquement conducteur (112) situé entre les gouttes (111).

**27.** Procédé de réalisation selon la revendication 17, **caractérisé en ce qu'**un matériau électriquement conducteur à faible mouillabilité (111) et un matériau électriquement conducteur (112) sont déposés en même temps sur une couche de l'empilement (110), ces matériaux étant non miscibles, ces matériau étant traités de manière à rendre diélectrique ou semi-conducteur le matériau électriquement conducteur (112).

**28.** Procédé de réalisation selon la revendication 17, **caractérisé en ce qu'**un matériau électriquement conducteur à faible mouillabilité conduisant à une pluralité de gouttes (111) est déposé sur une des couches (110) de l'empilement, cette couche de l'empilement étant traitée de manière à la rendre diélectrique ou semi-conductrice en surface et à assurer sa coopération avec les gouttes (111).

**29.** Procédé de réalisation selon l'une des revendications 24 à 28, **caractérisé en ce que** le traitement est une oxydation ou une nitruration.

**Patentansprüche**

**1.** Magnetoresistive Spinventil-Vorrichtung (1), gebildet durch einen Schichtenstapel mit wenigstens zwei magnetischen Schichten (2, 3), deren ihre Magnetisierungsrichtungen betreffende Ausrichtung unter dem Einfluss eines Magnetfelds variieren kann, und wenigstens eine dielektrische oder halbleitende Schicht (4), unterbrochen durch elektrisch leitfähige Brücken (5), welche die Dicke der dielektrischen oder halbleitenden Schicht durchqueren, wobei diese Brücken (5) dazu bestimmt sind, den quer in dem Stapel fließenden Strom lokal zu konzentrieren, Einrichtungen (6a, 6b) umfassend, um in dem Spinventil einen Strom quer zu der Ebene der Schichten fließen zu lassen,
**dadurch gekennzeichnet, dass** die dielektrische oder halbleitende Schicht (4) mit den elektrisch leitfähigen Brükken (5) in einer der magnetischen Schichten (3) angeordnet ist.

**2.** Magnetoresistive Vorrichtung nach Anspruch 1, **dadurch gekennzeichnet, dass** eine unmagnetische, elektrisch leitfähige durchgehende Trennschicht (9) eingefügt ist zwischen die dielektrische oder halbleitende Schicht (4) mit den elektrisch leitfähigen Brücken (5) und wenigstens eine der magnetischen Schichten (2, 3).

**3.** Magnetoresistive Vorrichtung nach einem der Ansprüche 1 oder 2, **dadurch gekennzeichnet, dass** die Brücken (5) aus dem Material der magnetischen Schicht (3) sind, welche die dielektrische oder halbleitende Schicht (4) aufnimmt.

**4.** Magnetoresistive Vorrichtung nach einem der Ansprüche 1 oder 2, **dadurch gekennzeichnet, dass** die elektrisch leitfähigen Brücken (5) aus einem unmagnetischen Material sind, ausgewählt unter den Edelmetallen wie Gold, Silber, Kupfer oder ihren Legierungen.

**5.** Magnetoresistive Vorrichtung nach einem der Ansprüche 1 bis 3, **dadurch gekennzeichnet, dass** die elektrisch leitfähigen Brücken (5) aus einem magnetischen Material wie Kobalt, Eisen, Nickel oder ihren Legierungen sind.

**6.** Magnetoresistive Vorrichtung nach einem der Ansprüche 1 bis 5, **dadurch gekennzeichnet, dass** das dielektrische oder halbleitende Material der diskontinuierlichen Schicht (4) magnetisch ist.

**7.** Magnetoresistive Vorrichtung nach einem der Ansprüche 1 bis 5, **dadurch gekennzeichnet, dass** das dielektrische oder halbleitende Material der diskontinuierlichen Schicht (4) unmagnetisch ist.

**8.** Magnetoresistive Vorrichtung nach einem der Ansprüche 1 bis 7, **dadurch gekennzeichnet, dass** wenigstens eine der magnetischen Schichten (2a) durch einen Stapel aus Zwischenschichten (2a1, 2a2, 2a3) gebildet wird.

**9.** Magnetoresistive Vorrichtung nach einem der Ansprüche 1 bis 8, **dadurch gekennzeichnet, dass** die Magnetisierungsrichtung von einer der magnetischen Schichten (2) festgelegt wird durch die Zuordnung einer antiferromagnetischen Schicht (8), angeordnet jenseits der magnetischen Schicht (2) mit fester Magnetisierungsrichtung in Bezug auf die dielektrische oder halbleitende Schicht (4) mit den elektrisch leitfähigen Brücken (5).

10. Magnetoresistive Vorrichtung nach Anspruch 9, **dadurch gekennzeichnet, dass** die magnetische Schicht (2a) mit fester Magnetisierungsrichtung durch eine unmagnetische, elektrisch leitfähige Zwischenschicht (2a1) gebildet wird, angeordnet zwischen zwei magnetischen Zwischenschichten (2a2, 2a3).

11. Magnetoresistive Vorrichtung nach einem der Ansprüche 1 bis 10, **dadurch gekennzeichnet, dass** die dielektrische oder halbleitende diskontinuierliche Schicht (4) realisiert ist auf Oxid-, Nitrid-, Halbleiterbasis.

12. Magnetoresistive Vorrichtung nach einem der Ansprüche 1 bis 11, **dadurch gekennzeichnet, dass** die Einrichtungen, um einen elektrischen Strom fließen zu lassen, zwei Elektroden (6a, 6b) umfassen, die das Spinventil (1) sandwichartig enthalten.

13. Magnetoresistive Vorrichtung nach Anspruch 12, **dadurch gekennzeichnet, dass** zwischen einer der Elektroden (6b) und dem Spinventil (1) eine Pufferschicht (7) vorgesehen ist.

14. Magnetoresistive Vorrichtung nach einem der Ansprüche 1 bis 13, **dadurch gekennzeichnet, dass** das Spinnventil dual ist.

15. Magnetlesekopf, **dadurch gekennzeichnet, dass** er eine magnetoresistive Vorrichtung nach einem der Ansprüche 1 bis 14 umfasst.

16. Speicher, eine Matrix aus Speicherpunkten umfassend, adressierbar durch Zeilen (103) und Spalten (105), **dadurch gekennzeichnet, dass** jeder Speicherpunkt gebildet wird durch eine mit einer Stromschalteinrichtung (102) kooperierende magnetoresistive Vorrichtung nach einem der Ansprüche 1 bis 14.

17. Verfahren zur Realisierung einer magnetoresistiven Spinventil-Vorrichtung (1), folgende Schritte umfassend:

Realisierung - zur Herstellung des Spinventils - eines Schichtenstapel mit wenigstens zwei magnetischen Schichten (2, 3), deren ihre Magnetisierungsrichtungen betreffende Ausrichtung unter dem Einfluss eines Magnetfelds variieren kann,
Realisierung von Einrichtungen (6a, 6b), um in dem Spinventil einen Strom quer zu der Ebene der Schichten fließen zu lassen,

**dadurch gekennzeichnet, dass** es einen Schritt zur Realisierung von wenigstens einer dielektrischen oder halbleitenden Schicht (4) mit die Schichtdicke durchquerenden elektrisch leitfähigen Brücken (5) in einer der magnetischen Schichten (2, 3) umfasst, wobei diese Brücken (5) dazu dienen, den quer durch den Stapel fließenden Strom zu konzentrieren.

18. Realisierungsverfahren nach Anspruch 17, **dadurch gekennzeichnet, dass** die dielektrische oder halbleitende Schicht (4) mit den elektrisch leitfähigen Brücken (5) durch Abscheidung einer dünnen Schicht (4) aus dielektrischem oder halbleitendem Material mit eingeschlossenen metallischen Teilchen realisiert wird, wobei diese metallischen Teilchen sich gruppieren bzw. umgruppieren, um die Brücken (5) zu bilden.

19. Realisierungsverfahren nach Anspruch 17, **dadurch gekennzeichnet, dass** die dielektrische oder halbleitende Schicht (4) mit den elektrisch leitfähigen Brücken (5) realisiert wird, indem eine elektrisch leitfähige, Schicht (9), die sich in dem Stapel befindet, um ihn dielektrisch oder halbleitend zu machen, lokal behandelt wird.

20. Realisierungsverfahren nach Anspruch 19, **dadurch gekennzeichnet, dass** die Behandlung während der Abscheidung oder am Ende der Abscheidung der elektrisch leitfähigen Schicht (9) stattfindet.

21. Realisierungsverfahren nach Anspruch 17, **dadurch gekennzeichnet, dass** man die dielektrische oder halbleitende Schicht (4) mit den elektrisch leitfähigen Brücken (5) realisiert, indem man eine Isolierschicht (4) mit Unterbrechungen zwischen zwei elektrisch leitfähigen Schichten (9-1, 9-2) des Stapels einfügt und indem man das elektrisch leitfähige Material durch die Unterbrechungen der Isolierschicht (4) diffundieren lässt.

22. Verfahren nach Anspruch 21, **dadurch gekennzeichnet, dass** die Unterbrechungen in der Isolierschicht (4) natürlich sind.

**23.** Verfahren nach Anspruch 21, **dadurch gekennzeichnet, dass** die Unterbrechungen in der Isolierschicht (4) künstlich erzeugt werden.

**24.** Realisierungsverfahren nach Anspruch 17, **dadurch gekennzeichnet, dass** man die dielektrische oder halbleitende Schicht (4) mit den elektrisch leitfähigen Brücken (5) realisiert, indem man ein elektrisch leitfähiges Material mit geringer Benetzbarkeit verwendet, um bei seiner Abscheidung eine Vielzahl von Tropfen (111) zu erhalten, indem man darauf ein mit den Tropfen nicht mischbares elektrisch leitfähiges Material (112) abscheidet, um die Räume zwischen den Tropfen zu füllen, und indem man eine Behandlung des elektrisch leitfähigen Materials durchführt, das sich zwischen den Tropfen befindet, um es dielektrisch oder halbleitend zu machen.

**25.** Realisierungsverfahren nach Anspruch 24, **dadurch gekennzeichnet, dass** die Dicke des elektrisch leitfähigen Materials (112) etwas kleiner ist als die der Tropfen (111).

**26.** Realisierungsverfahren nach Anspruch 17, **dadurch gekennzeichnet, dass** ein elektrisch leitfähiges Material (112), das zur Bildung der dielektrischen oder halbleitenden Schicht dient, auf einer der Schichten (110) des Stapels abgeschieden wird, ein elektrisch leitfähiges Material mit geringer Benetzbarkeit (111), was zur Bildung einer Vielzahl von Tropfen führt, darauf abgeschieden wird, und eine Behandlung durchgeführt wird, um das zwischen den Tropfen (111) befindliche elektrisch leitfähige Material (112) dielektrisch oder halbleitend zu machen.

**27.** Realisierungsverfahren nach Anspruch 17, **dadurch gekennzeichnet, dass** ein elektrisch leitfähiges Material mit geringer Benetzbarkeit (111) und ein elektrisch leitfähiges Material (112) gleichzeitig auf einer Schicht (110) des Stapels abgeschieden werden, wobei diese Materialien, die nicht mischbar sind, behandelt werden, um das elektrisch leitfähige Material (112) dielektrisch oder halbleitend zu machen.

**28.** Realisierungsverfahren nach Anspruch 17, **dadurch gekennzeichnet, dass** ein elektrisch leitfähiges Material mit geringer Benetzbarkeit (111), das zu einer Vielzahl von Tropfen (111) führt, auf einer der Schichten (110) des Stapels abgeschieden wird, wobei diese Schicht des Stapels behandelt wird, um sie an der Oberfläche dielektrisch oder halbleitend zu machen und ihre Kooperation mit den Tropfen (111) zu gewährleisten.

**29.** Realisierungsverfahren nach einem der Ansprüche 24 bis 28, **dadurch gekennzeichnet, dass** die Behandlung eine Oxidierung oder eine Nitrierung ist.

**Claims**

**1.** Magnetoresistive device comprising a spin valve (1) formed from a stack of layers including at least two magnetic layers (2, 3) for which the relative orientation of their magnetisation directions can vary under the influence of a magnetic field, and at least one discontinuous dielectric or semiconducting layer (4) with electrically conducting bridges (5) passing through the thickness of the dielectric or semiconducting layer, these bridges (5) being designed to locally concentrate the current that passes transversely through the stack, comprising means (6a, 6b) of circulating a current in the spin valve transverse to the plane of the layers, **characterised in that** the dielectric or semiconducting layer (4) with electrically conducting bridges (5) is arranged in one of the magnetic layers (3).

**2.** Magnetoresistive device according to claim 1, **characterised in that** a continuous non-magnetic electrically conducting separating layer (9) is inserted between the dielectric or semiconducting layer (4) with the electrically conducting bridges (5) and at least one of the magnetic layers (2, 3).

**3.** Magnetoresistive device according to either of claims 1 or 2, **characterised in that** the bridges (5) are made from the material of the magnetic layer (3) in which the dielectric or semiconducting layer (4) is located.

**4.** Magnetoresistive device according to either of claims 1 or 2, **characterised in that** the electrically conducting bridges (5) are made from a non-magnetic material chosen from among noble metals such as gold, silver, copper or alloys of gold, silver and copper.

**5.** Magnetoresistive device according to one of claims 1 to 3, **characterised in that** the electrically conducting bridges (5) are made from a magnetic material such as cobalt, iron, nickel or alloys of cobalt, iron or nickel.

**6.** Magnetoresistive device according to one of claims 1 to 5, **characterised in that** the dielectric or semiconducting material in the discontinuous layer (4) is magnetic.

**7.** Magnetoresistive device according to one of claims 1 to 5, **characterised in that** the dielectric or semiconducting material in the discontinuous layer (4) is non-magnetic.

**8.** Magnetoresistive device according to one of claims 1 to 7, **characterised in that** at least one of the magnetic layers (2a) is formed from a stack of intermediate layers (2a1, 2a2, 2a3).

**9.** Magnetoresistive device according to one of claims 1 to 8, **characterised in that** one of the magnetic layers (2) has a magnetisation direction fixed by the association of an antiferromagnetic layer (8) arranged beyond the magnetic layer with magnetisation direction (2) fixed with respect to the dielectric or semiconducting layer (4) with the electrically conducting bridges (5).

**10.** Magnetoresistive device according to claim 9, **characterised in that** the magnetic layer (2a) with a fixed magnetisation direction is formed from an intermediate electrically conducting non-magnetic layer (2a1) surrounded by two intermediate magnetic layers (2a2, 2a3).

**11.** Magnetoresistive device according to one of claims 1 to 10, **characterised in that** the discontinuous dielectric or semiconducting layer (4) is made based on an oxide, nitride or a semiconductor.

**12.** Magnetoresistive device according to one of claims 1 to 11, **characterised in that** the means of circulating an electric current comprise two electrodes (6a, 6b) that hold the spin valve (1) like in a sandwich.

**13.** Magnetoresistive device according to claim 12, **characterised in that** at least one buffer layer (7) is inserted between one of the electrodes (6b) and the spin valve (1).

**14.** Magnetoresistive device according to one of claims 1 to 13, **characterised in that** the spin valve (1) is dual.

**15.** Magnetic read head, **characterized in that** it comprises a magnetoresistive device according to one of claims 1 to 14.

**16.** Memory comprising a matrix of memory dots addressable by rows (103) and columns (105), **characterised in that** each memory dot comprises a magnetoresistive device (101) according to one of claims 1 to 14 cooperating with a current switching means (102).

**17.** Process for making a magnetoresistive device with a spin valve (1), comprising the following steps:

manufacture of a stack of layers (2, 3) to form the spin valve, including at least two magnetic layers for which the relative orientation of their magnetisation directions can vary under the effect of a magnetic field, production of means (6a, 6b) of circulating a current in the spin valve (1) transverse to the plane of the layers,

**characterised in that** it comprises a step for manufacturing at least one discontinuous dielectric or semiconducting layer (4) with electrically conducting bridges (5) passing through the thickness of the layer, in one of the magnetic layers (2, 3), these bridges (5) being designed to locally concentrate the current that passes transversely through the stack.

**18.** Manufacturing process according to claim 17, **characterised in that** the dielectric or semiconducting layer (4) with the electrically conducting bridges (5) is made by the deposition of a thin layer (4) of dielectric or semiconducting material including metallic particles, and these metallic particles are grouped to form the bridges (5).

**19.** Manufacturing process according to claim 17, **characterised in that** the dielectric or semiconducting layer (4) with the electrically conducting bridges (5) is made by locally treating an electrically conducting layer (9) located in the stack to make it dielectric or semiconducting.

**20.** Manufacturing process according to claim 19, **characterised in that** the treatment takes place during deposition or at the end of the deposition of the electrically conducting layer (9).

**21.** Manufacturing process according to claim 17, **characterised in that** the dielectric or semiconducting layer (4) with the electrically conducting bridges (5) is made by placing an insulating layer (4) with discontinuities between two electrically conducting layers (9-1, 9-2) in the stack and by making the electrically conducting material diffuse through the discontinuities in the insulating layer (4).

**22.** Process according to claim 21, **characterised in that** discontinuities exist naturally in the insulating layer (4).

**23.** Manufacturing process according to claim 21, **characterised in that** discontinuities are created artificially in the insulating layer (4).

**24.** Manufacturing process according to claim 17, **characterised in that** the dielectric or semiconducting layer (4) with the electrically conducting bridges (5) is made using an electrically conducting material with low wettability, so as to obtain a plurality of drops (111) when it is deposited, and depositing an electrically conducting material (112) on top, which is not miscible with the drops so as to fill in the spaces between the drops, and by performing a treatment for the electrically conducting material located between the drops to make it dielectric or semiconducting.

**25.** Manufacturing process according to claim 24, **characterised in that** the thickness of the electrically conducting material (112) is slightly less than the thickness of the drops (111).

**26.** Manufacturing process according to claim 17, **characterised in that** an electrically conducting material (112) leading to the discontinuous dielectric or semiconducting layer is deposited on one of the layers of the stack (110), an electrically conducting material with low wettability (111) creating a plurality of drops being deposited on top of it, and a treatment being carried out to make the electrically conducting material (112) located between the drops (111) dielectric or semiconducting.

**27.** Manufacturing process according to claim 17, **characterised in that** an electrically conducting material (111) with low wettability and an electrically conducting material (112) are deposited at the same time on a layer of the stack (110), these materials being immiscible and treated to make the electrically conducting material (112) dielectric or semiconducting.

**28.** Manufacturing process according to claim 17, **characterised in that** an electrically conducting material with low wettability creating a plurality of drops (111) is deposited on one of the layers (110) in the stack, this layer in the stack being treated so as make it dielectric or semiconducting on the surface and to enable it to cooperate with the drops (111).

**29.** Manufacturing process according to. one of claims 24 to 28, **characterised in that** the treatment is an oxidation or a nitridation.

**Fig. 1**

**Fig. 2**

Fig. 3

Fig. 4

Fig. 5A

Fig. 5B

Fig. 5C

Fig. 6

Fig. 7

Fig. 8

Fig. 9

Fig. 10

112 111

5

110 **Fig. 11A**

5

111

113

111

112

110 **Fig. 11B**

112 111

110 **Fig. 11C**